Europäisches Patentamt

European Patent Office

Office européen des brevets

(19)

(11) Publication number: **0 209 972**
**A1**

(12) **EUROPEAN PATENT APPLICATION**

(21) Application number: 86304045.7

(22) Date of filing: 28.05.86

(51) Int. Cl.⁴: **C 23 C 14/06**

(30) Priority: 05.06.85 GB 8514247

(43) Date of publication of application:
28.01.87 Bulletin 87/5

(84) Designated Contracting States:
BE DE FR GB

(71) Applicant: PLESSEY OVERSEAS LIMITED
Vicarage Lane
Ilford Essex IGI 4AQ(GB)

(72) Inventor: Pedder, David John
1A Davenant Road
Oxford OX2 8BT(GB)

(72) Inventor: Dennis, Paul Vincent
51 Keats Drive
Towcester Northampton(GB)

(72) Inventor: Lettington, Alan
86 Arundel Drive
Worcester WR5 2HY(GB)

(74) Representative: Sorenti, Gino
Intellectual Property Department The Plessey Company
plc 2-60 Vicarage Lane
Ilford Essex IG1 4AQ(GB)

(54) **Methods of depositing germanium hydrogen carbide.**

(57) A prior art method of depositing Germanium Hydrogen Carbide involves the use of glow discharge techniques which involve high substrate temperatures and explosive gases. Methods according to the present invention comprise exposing a target (7) of Germanium to a plasma (9) comprising an inert gas and a hydrocarbon gas. The plasma (9) is maintained by means of a radio frequency magnetron electrode (6) which is associated with the target (7). Atoms and ions of Germanium, Hydrogen and Carbon are sputtered onto the substrate (2) in order to deposit the Germanium Hydrogen Carbide.

EP 0 209 972 A1

- 1 -

## METHODS OF DEPOSITING GERMANIUM HYDROGEN CARBIDE

This invention relates to methods of depositing Germanium Hydrogen Carbide, and in particular to methods which involve reactive radio frequency magnatron sputtering techniques.

A previously proposed method of depositing Germanium Hydrogen Carbide involves the use of glow discharge techniques. Such techniques are disadvantageous in that they involve high substrate temperatures and explosive gasses, and deposition of the Germanium Hydrogen Carbide is relatively slow. Due to the high substrate temperatures, the Germanium Hydrogen Carbide deposited by such methods is subjected to high stresses as a result of differing coefficients of expansion between the substrate on which the Germanium Hydrogen Carbide is deposited and the Germanium Hydrogen Carbide itself. When the Germanium Hydrogen Carbide is subjected to such stresses, the infra-red absorption coefficient of the Germanium Hydrogen Carbide is increased. Further, the unwanted stress imposes limitations on the thickness of the Germanium Hydrogen Carbide which can be usefully deposited.

It is an aim of the present invention to provide a method which permits relatively fast deposition of thicker layers Germanium Hydrogen Carbide at lower substrate temperatures.

According to the present invention, there is provided a method of depositing Germanium Hydrogen Carbide on a substrate, the method comprising exposing a target of Germanium to a plasma comprising an inert gas and a hydrocarbon gas, maintaining the plasma by means of a radio frequency magnetron electrode which is associated with the target, and sputtering atoms and ions of Germanium, Hydrogen and Carbon onto the substrate in order to deposit the Germanium Hydrogen Carbide.

The inert gas is preferably Argon and the hydrocarbon is preferably of Methane or Butane.

The composition of Germanium Hydrogen Carbide preferably consists of 79% Germanium, 14% Carbon and 7% Hydrogen. However, alternative compositions may be 54% Germanium, 24% Carbon and 22% Hydrogen, or 65% Germanium, 32% Carbon and 2.6% Hydrogen. The aforementioned compositions are expressed in atomic percentages and it is understood that variations of the particular atomic percentages quoted may provide the advantages afforded by the present invention. Consequently, it is intended that such variations fall within the scope of the present invention.

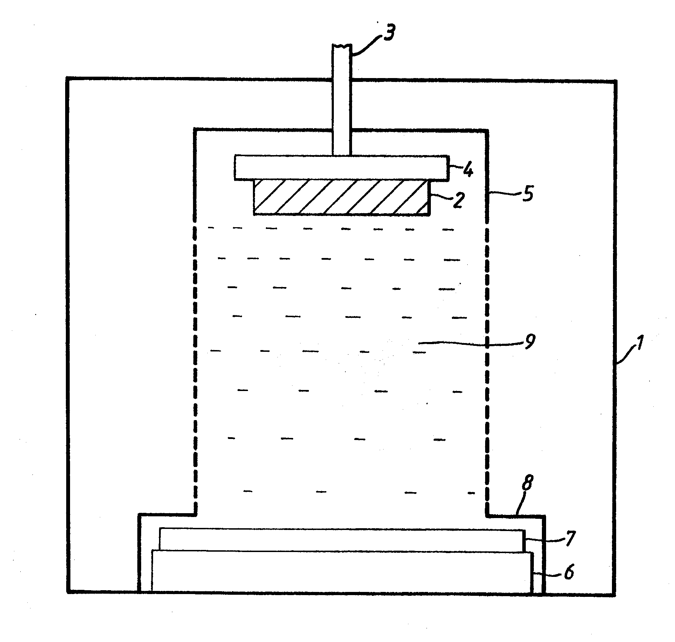

The invention will now be further described by way of example with reference to the accompanying drawing, in which there is shown a schematic diagram of an apparatus suitable for performing a method embodying the present invention.

In the drawing there is shown a vacuum chamber 1 in which Germanium Hydrogen Carbide is to be deposited on a substrate 2. A vacuum feed-through 3 provides power for electrically heating a heater 4 which in turn heats the substrate 2 on which the Germanium Hydrogen Carbide is deposited. A shield 5 surrounds part of the substrate and is electrically connected to earth in order to confine deposition to the substrate 2.

At an end of the vacuum chamber 1 remote from the substrate 2, there is provided a radio frequency magnetron electrode 6, which electrode 6 may be water cooled, on which is located a target 7 of Germanium. A target shield and anode ring 8 is provided around part of the target 7 and the radio frequency magnetron electrode 6 in order to define an area of the target 7 which is to be eroded.

When the apparatus is in use, the radio frequency magnetron electrode 6 is switched on to provide sufficient power to maintain a plasma 9 between the substrate 2 and the Germanium target 7. The plasma 9 comprises an inert gas, in this case Argon, and a reactive gas, in this case a hydrocarbon such as Methane. The plasma 9 sputters the Germanium target 7 and causes Germanium ions to be ejected from the target 7 and to pass through the plasma 9 to the substrate 2. Electrons which are left due to the production of Germanium ions are confined in the region of the target 7 by the magnetic field produced by the magnet of the magnetron electrode 6. Any build up of electronic charge drains away to earth via the target shield and anode ring 8.

By controlling the ratio of Argon and Hydrocarbon fed into the vacuum chamber 1, the composition of Germanium Hydrogen Carbide formed on the substrate 2 can be carefully controlled. By depositing the Germanium Hydrogen Carbide by this method, high depositon rates of, for example, at least 10 micrometers per hour can be achieved. In addition, the temperature of the substrate may be maintained at a relatively low temperature, for example, of less than 300° Centigrade. Use of the radio frequency magnetron electrode 6 has an additional advantage that secondary electron bombardment of the substrate 2 is reduced due to the fact that electrons produced at the target 7 are confined close to the region of the target shield and anode ring 8.

Germanium Hydrogen Carbide produced according to a method embodying the present invention has special properties in that it is much harder than pure Germanium, and it has an infra-red absorption coefficient which increases with temperature to a lesser degree than the pure element Germanium. The preferred composition, which comprises 79.0% Germanium, is hard and has the lowest infra red-absorption coefficent of the three specific compositions mentioned above. The third composition having 65.0% Germanium, is harder than the aforementioned composition but has a higher infra-red absorption coefficient. The second composition, which comprises 54.0% Germanium, is a compromise between the preferred and the third compositions in that it is hard and has an infra-red absorption coefficient between that of the two aforementioned compositions.

CLAIMS:

1.     A method of depositing Germanium Hydrogen Carbide on a substrate (2), the method comprising exposing a target (7) of Germanium to a plasma (9) comprising an inert gas and a hydrocarbon gas, maintaining the plasma by means of a radio frequency magnetron electrode (6) which is associated with the target (7), and sputtering atoms and ions of Germanium, Hydrogen and Carbon onto the substrate (2) in order to deposit the Germanium Hydrogen Carbide.

2.     A method according to claim 1, wherein the inert gas is Argon and the hydrocarbon gas is methane or butane.

3.     A composition of Germanium Hydrogen Carbide produced by a method according to claim 1 or claim 2, wherein the composition comprises 79% Germanium, 14% Carbon and 7% Hydrogen.

4.     A composition of Germanium Hydrogen Carbide produced by a method according to claim 1 or claim 2 wherein the composition comprises 54% Germanium, 24% Carbon and 22% Hydrogen.

5.    A composition of Germanium Hydrogen Carbide produced by a method according to claim 1 or claim 2 wherein the composition comprises 65% Germanium, 32% Carbon and 2.6% Hydrogen.

1/1

0209972

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| A | EP-A-0 106 638 (NATIONAL RESEARCH DEVELOPMENT) * Claims 1-12; page 6 * | 1,2 | C 23 C 14/06 |
| A | EP-A-0 104 916 (NATIONAL RESEARCH DEVELOPMENT) * Claims 1,2,6 * | 1 | |
| A | EP-A-0 137 697 (K.K. TOSHIBA) * Claims 1,3,4 * | 1,2 | |
| A | EP-A-0 032 788 (NATIONAL RESEARCH DEVELOPMENT) | | |
| A | EP-A-0 106 637 (NATIONAL RESEARCH DEVELOPMENT) | | |

TECHNICAL FIELDS SEARCHED (Int Cl 4)

C 23 C

The present search report has been drawn up for all claims

| Place of search | Date of completion of the search | Examiner |
|---|---|---|
| THE HAGUE | 08-10-1986 | ELSEN D.B.A. |